# EUROPEAN PATENT SPECIFICATION

(11) **EP 1 446 000 B1**
(45) Date of publication and mention of the grant of the patent: **09.11.2011**
(21) Application number: 03388026.1
(22) Date of filing: 25.04.2003
(51) Int. Cl.: H05K 9/00

(54) **A shield can for shielding electronic components on a PWB**
Abschirmkappe zum Abschirmung elektronischer Komponenten auf eine Leiterplatte
Capot de blindage pour composants électroniques sur un circuit imprimé

(30) Priority: 07.02.2003 EP 03388005
(43) Date of publication of application: 11.08.2004
(73) Proprietor: Sony Ericsson Mobile Communications AB, 221 88 Lund (SE)
(72) Inventor: Fagrenius, Gustav, 224 68 Lund (SE); Bengtsson, Henrik, 224 65 Lund (SE); Andersson, Niklas, 226 44 Lund (SE); Palmqvist, Fredrik, 245 92 Staffanstorp (SE)
(74) Representative: Banzer, Hans-Jörg

(56) References cited:
- EP-A- 1 130 953
- WO-A-02/052916
- DE-C- 19 840 234
- US-A- 5 566 055
- US-A- 5 608 188
- US-A- 6 051 780
- PATENT ABSTRACTS OF JAPAN vol. 1998, no. 05, 30 April 1998 (1998-04-30) & JP 10 022679 A (SAITAMA NIPPON DENKI KK), 23 January 1998 (1998-01-23)

## Description

### Technical field

The invention relates to a shield can for shielding electronic components on a PWB (printed wired board) in an electronic device, said shield can comprising substantially vertical side walls with a lower rim.

### Related prior art

In order to shield electronic components on a PWB (printed wired board) in electronic devices against electro-magnetic radiation, a shielding in the form of an electrically conductive shield can or box is conventionally placed on the PWB covering the electronic components. The highest level of shielding is achieved when a closed metal can with a free rim at downwardly extending side walls is soldered to the PWB along the entire free edge of the metal can. A critical requirement that must be fulfilled in order to achieve good shielding is that the solder joint between the shield can and the PWB is well controlled, preferably without leaving any unsoldered areas. If any areas remain unsoldered the shielding efficiency is determined by the largest gap between the shield can and the PWB. Therefore, if gaps exist between the shield can and the PWB the sizes of these must be well defined.

The preferred method today for mounting electronic components to the PWB is to use the so-called surface mount technology (SMT) with a re-flow soldering method. In this method a solder paste is used which is a substance with cream-like consistency made up of solder, flux and a carrying medium. The mixture of solder and flux is 85%-95% solder and 5%-15% flux, where the solder consists of small particles shaped as balls and needles. There are high quality demands on the solder paste, when used in the electronic industry. The solder paste should e.g. easily wet the components and the pads on the PWB, not flow so much that it connects two nearby pads on the PWB, be sticky to hold the components during assembly and not get stuck in the holes of the screen-printing stencil, when such a stencil is used for applying the solder paste.

The first step in a soldering process is to apply the solder paste to pads on the PWB. This can be done by several methods including:
- Dispense solder paste through the end of a tube.
   This method is very similar to using a syringe. The solder paste is slightly pressurised and is dispensed through the end of a tube. Advantages of this method are for example that it allows little opportunity for solder contamination, since it employs a closed container for the solder paste. Other advantages include that the tube can reach into odd shaped places and that it is a relatively inexpensive method. Disadvantages of this method include that it is very difficult to apply the precise amount of solder paste to the PWB and that it is a relatively slow method.
- Dip dull pins into the solder paste.
   When using this method, dull pins are dipped into solder paste and the ends of the pins are then dabbed onto the PWB. The amount of solder paste is directly proportional to the size and shape of the pins. An advantage of this method is that it is fast, since it is possible to lower a whole array of pins onto the board at the same time.
- Screen-printing.
   Screen-printing is a method that yields an excellent result when applying solder paste, since it gives an exact and predetermined thickness of the layer of solder paste. A screen-printing stencil is made by a fine mesh of polyester or metal. The screen-printing stencil is placed slightly above the PWB and a squeegee is drawn over the stencil with a pressure that forces the solder paste through the stencil onto the PWB. The squeegee could be made of metal or rubber. If it is made of rubber, it is possible to put different amounts of solder paste on different places on the PWB. However, it has to be sharpened quite often.
- Stencil-printing.
   This method is very similar to screen-printing. The difference is that the stencil is not elastic and therefore the stencil is placed in contact with the PWB. Stencil-printing is mostly used for fine-pitch devices. This is a method that is perfectly suitable for high-volume production.

The preferred method for applying the solder paste to the PWB is the screen printing method described above. The PWB is screen-printed with solder paste at the desired areas where electronic components and the shield can(s) are to be mounted. The thickness of the solder paste is determined by the thickness of the screen-printing stencil and is the same all over the PWB.

The next step is to place the electronic components on the PWB by a pick-and-place machine. The shield can(s) is (are) normally placed on the PWB after the other components have been placed since shield cans must cover one or more of them. In the last step of the process the PWB is heated in a soldering oven, whereby the applied solder paste melts and all the components and the shield can(s) become soldered to the PWB.

When the PWB, together with the components, travels through the oven to melt the solder paste, the temperature follows a predetermined pattern. The oven is first heated to a temperature where the flux in the solder paste becomes active and the temperature is held for a period of time that is long enough to let the flux clean the base metal. After this, the temperature is raised above the melting temperature of the solder paste. The temperature is usually held at this level for 30 to 60 seconds, long enough to let the solder wet the PWB and the components. The last step is cooling the PWB, which is done at a continuous rate. There is a trade off in the cooling process. If the PWB is cooled quickly, the solder bonds will be strong, but it will introduce stresses in the PWB. Therefore, the cooling process must be controlled for ensuring a relatively strong bond without introducing too high stresses in the PWB.

Since small components, such as resistors and capacitors, need small volumes of solder paste and large components, such as shield cans, need large volumes of solder pate, the thickness of the screen-printing stencil has to be set as a compromise between these two different needs. Electronic components are constantly getting smaller in order to save space on the PWB, and smaller electronic components must have less solder paste in order to get soldered properly. Thinner screen-printing stencils will therefore be used in the future.

However, neither the shield cans nor the PWBs can be manufactured perfectly flat and, furthermore, the non-planarity of especially the PWB may be affected by the heat in the soldering oven. This means that there will always be a gap between the shield can and the PWB, which, however, is not a problem as long as the gap is filled with solder during heating. As described above the thickness of the solder paste initially applied to the PWB is limited and may in the future be decreased even further. This means that the acceptable size of the gap is also limited, if it must be ensured that the gap becomes filled with solder during the heating process. Furthermore, the size of the gap between the shield can and the PWB increases with the size of the shield can, and the size of the shield can must therefore be limited in order to ensure that the gap can be filled with the pre-applied solder paste.

In modern electronic devices that tend to be increasingly smaller it is desirable to combine several small shield cans into one large shield can with internal walls, since this will save space on the PWB. Fewer shield cans also result in faster assembling and a reduction in the manufacturing costs. Larger shield cans will, however, increase the risk for unsoldered gaps between the shield can and the PWB due to a non-planar PWB and/or a non-planar shield can.

An attempt to overcome this problem has been to dispense an extra thick layer of solder paste to the area of the PWB where the shield can is to be positioned. However, this calls for an undesired extra manufacturing step.

In WO 02/052916 A1, a containment enclosure for electronic devices is described. The containment enclosure is based on a containment form shell which may comprise gap-filling punctures, gap-filling bent tabs, or gap-filling dimples formed at a rim of the containment form shell.

### Object of the invention

It is an object of the invention to provide a shield can for shielding electronic components on a PWB by which the risk of unacceptable gaps between the mounted shield can and the PWB is eliminated.

### Summary of the invention

The object of the invention is achieved by providing vertically adjustable sections at the rim of the side walls of the shield can. More specifically, the invention provides a shield can according to claim 1. The dependent claim defines a preferred embodiment of the invention.

Thereby is achieved that any non-planarity of the PWB can be compensated for by proper adjustment of the sections that extend beyond the lower rim of the shield can such that all sections abut on the PWB. The ends of the sections, which constitute the actual lowermost rim of the shield can, thereby abut on the PWB and no gaps will be present between the shield can and the PWB. A shield can arranged with such vertically adjustable sections can be used on non-planer PWBs without any need for increasing the amount of solder paste initially applied to the PWB. Additionally, the shield can may also be used in the future even if the thickness of the solder paste applied to the PWB is decreased.

According to the invention, the sections are freely suspended in at least one slot provided at each side wall of the shield can. Thereby the sections always tend to extend as far as possible beyond the lower rim of the side walls of the shield can.

The slot is provided in a horizontal lower part of the side wall. This makes the structure of the shield can especially simple.

In order to prevent the sections from disengaging from the side walls of the shield can each section can be provided with a protrusion at an upper end thereof adapted to engage the horizontal lower part of the side wall.

It shall be emphasised that the term "comprise/comprising" when used in this specification is taken to specify the presence of stated features, integers, steps or components, but does not preclude the presence or addition of one or more other features, integers, steps, components or groups thereof.

### Description of the drawings

The invention will be described in detail in the following with reference to the drawings in which
Figs 1 a and 1b illustrate the problems associated with the prior art shield cans;
Fig. 2 shows a first embodiment of a shield can according to the invention;
Fig. 3 shows in cross-section a part of the shield can shown in Fig. 2;
Fig. 4 shows the shield can shown in Fig. 2 mounted on a PWB; and
Figs 5a and 5b show in cross-sections another example of a shield can.

### Detailed description of an embodiment of the invention

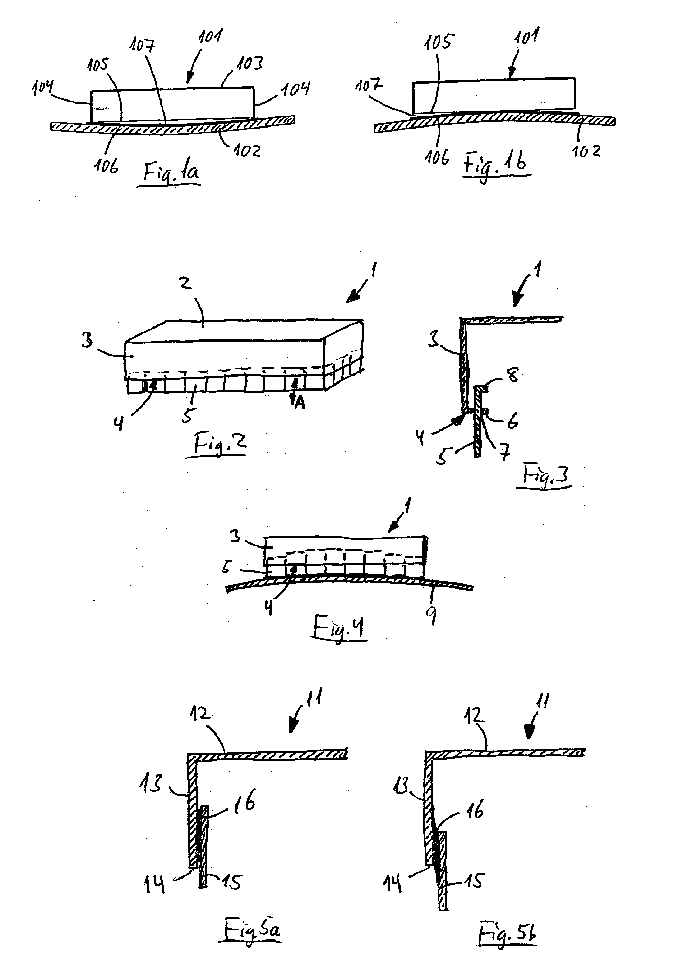

Figs 1 a and 1b show cross-sections taken through a shield can 101 and a PWB 102 and illustrate the problems associated with the prior art method for mounting a shield can 101 on a PWB 102. In the embodiment shown, the shield can 101 is box-shaped and consists of a metal shell forming a flat upper cover part 103 and four downwardly extending side walls 104 with a free rim 105. As described above PWBs 102 are never totally planar due to internal stresses in the PWB 102 occasioned by the manufacturing process. Figs 1 a and 1 b each shows a PWB 102 that bends downwards and upwards, respectively. In order to better illustrate the problems associated with the prior art mounting of a shield can 101 on a PWB 102 the bending of the PWBs 102 as shown in Figs 1 a and 1b is exaggerated. Furthermore, for clarity reasons no other components than the shield can 101 is shown; in practice the electronic components to be shielded are positioned on the PWB 102 within the mounted shield can 101. In Figs 1a and 1b the PWB 102 is provided with a pre-applied thin layer of solder paste 106 provided at the area where the rim 105 of the shield can 101 is intended to be connected to the PWB 102 by heating of the pre-applied solder paste 106.

In Fig. 1a the PWB 102 bends downwards, and due to this downwards bending a gap 107 exists between the PWB 102 and the rim 105 of the shield can 101. It is not possible to close the gap 107 with the pre-applied solder paste 106, and if the PWB 102 bends as much as shown in Fig. 1a the gap 107 extends from one side of the shield can 101 to the other. Thereby the shielding efficiency is substantially reduced.

In the situation shown in Fig. 1b the PWB 102 bends upwards and the rim 105 of the shield can 101 is connected to the PWB 102 at a very limited area only. In this instance the gap 107, which is not closed by the pre-applied solder paste 106, between the PWB 102 and the rim 105 of the shield can 101 extends over more than two sides of the shield can 101. Again the shielding efficiency of the shield can 101 is substantially reduced.

In practice, the PWB 102 bends less than shown in Figs 1 a and 1b and the gap 107 is smaller than shown. However, since the degree of bending of the PWB 102 - and of the shield can 101 as well - is to some degree unpredictable, there is always a risk that a gap 107 of an unpredictable size occurs, thereby reducing the shielding efficiency.

Fig. 2 shows a first embodiment of a shield can 1 according to the invention. The shield can 1 comprises an upper cover part 2 and four vertical side walls 3 extending downwards from the upper cover part 2. Each side wall 3 has a lower rim 4. At the lower rim 4 of the side walls 3 further downwards extending sections 5 are provided. The sections 5 are arranged adjustably in the vertical direction in relation to the side walls 3 as indicated by the double arrow A.

In a preferred embodiment the sections 5 are attached to the side walls 3 in the manner shown in greater detail in Fig. 3 that shows a cross-section of a part of the shield can 1 shown in Fig. 2. Fig. 3 shows that the side wall 3 of the shield can 1 is provided with a horizontal lower part 6 at the rim 4. The horizontal lower part 6 is provided with a slot 7 through which the section 5 extends in a free slidable manner. The section 5 is thereby suspended by the slot 7 provided in the horizontal lower part 6 of the side wall 3. The horizontal lower part 6 of the side wall 3 may be provided with one elongate slot 7 extending from one end of the side wall 3 to the other through which all the sections 5 (see Fig. 2) extend. Alternatively, the horizontal lower part 6 may be provided with a plurality of slots 7 corresponding to the number of vertically adjustable sections 5 such that the sections 5 are suspended by distinct slots 7.

In order to ensure that the sections 5 do not fall through the slot 7, a protrusion 8 is provided at the upper end of the section 5. Since the sections 5 are freely suspended in the horizontal lower part 6 of the side wall 3 the protrusion 8 engages the horizontal lower part 6 of the side wall 3 when the shield can 1 is lifted from a surface.

Fig. 4 shows the shield can 1 mounted on a PWB 9 that bends upwards. The degree of bending is exaggerated in order better illustrate the gist of the invention. It is clearly seen how the non-planarity of the PWB 9 is compensated for by the sections 5 that extend in different lengths beneath the rim 4 of the side wall 3 of the shield can 1. The sections 5 thereby adjust themselves to the shape of the PWB 9 and create contact with the PWB 9 regardless of any non-planarity of the PWB 9.

Thereby the amount of solder paste initially applied to the PWB 9 need not be increased since each adjustable section 5 abuts on the PWB 9 without leaving any gaps between the lower edges of the sections 5 and the non-planar PWB 9.

Figs 5a and 5b show in cross-section a part of another example of a shield can 11. In this example the shield can is also provided with side walls 13 that extend downwardly from the upper cover part 12. The side walls 13 are provided with adjustable sections 15 that extend beyond the rim 14 of the side walls 13 as shown. The sections 15 may have the same general size as the sections 5 shown in Figs 2-4.

In the example shown in Figs 5a and 5b each section 15 is attached to the side walls 13 by means of extra solder 16 provided between the inner surface of the side wall 13 and the section 15. Initially, i.e. before the shield can 11 is mounted on the PWB, the section 15 is positioned as shown in Fig. 5a in relation to the side wall 13. When the shield can 11 is positioned on the PWB and the assembly is heated for melting the solder paste applied to the PWB, the extra amount of solder 16 provided between the side wall 13 and the section 15 also melts and allow the section 15 to be displaced upwards or downwards in relation to the side wall 13. In Fig. 5b is shown how the section 15 is displaced downwards in relation to the side wall 13, which displacement is the result if the top surface of the PWB is located at a lower level than the lower edge of the section 15 in the position shown in Fig. 5a. If the PWB was located at a higher level than the lower edge of the section 15 in the position shown in Fig. 5a the section 15 would have been pushed upwards in relation to the side wall 13 (not shown). The neighbouring sections (not shown) will similarly be displaced upwards or downwards in relation to the initial position on the side wall 13 depending on the non-planarity of the PWB on which the shield can 11 is mounted.

The invention has been described with reference to preferred embodiments employing a box-shaped shield can. However, the shield can need not be box-shaped; it may also be dome-shaped or shaped as any other hollow, three-dimensional member provided with a downwardly extending rim. The shield can may also be provided with internal walls that extend from the upper cover part of the shield can to the PWB for dividing the shield can into any desired closed volumes. Such internal walls should be provided with sections similar to those shown in Figs 2-5b or some other means for compensating for non-planarity of the PWB.

When choosing the material of the shield can, there is a wide selection of different materials to choose from. Different types of plastic materials and metal alloys with varying shielding characteristics are used on the market. Metal cans are mainly used for non-complicated geometries and are relatively inexpensive. The possibilities to create more complicated geometries increase when using a plastic material, but these types of shield cans are often more expensive to produce. In order to obtain sufficient shielding effectiveness, the plastic material must be conductive and this is achieved by e.g. spraying it with conductive paint.

## Claims

1. A shield can (1) for shielding electronic components on a printed wired board (9) in an electronic device, said shield can (1) comprising substantially vertical side walls (3) with a lower rim (4),
wherein vertically adjustable sections (5) are provided at the rim (4) of the side walls (3) of the shield can (1),
**characterised in that** at least one slot (7) is provided in a horizontal lower part (6) of each side wall (3) of the shield can (1),
wherein the sections (5) are suspended in the at least one slot (7) provided at each side wall (3) and extend in a freely slidable manner through the slot (7).

2. A shield can according to claim 1, **characterised in that** each section (5) is provided with a protrusion (8) at an upper end thereof adapted to engage the horizontal lower part (6) of the side wall (3).

## Patentansprüche

1. Abschirmkappe (1) zur Abschirmung elektronischer Komponenten auf einer Leiterplatte (9) in einem elektronischen Gerät, wobei die Abschirmkappe (1) im Wesentlichen vertikale Seitenwände (3) mit einem unteren Rand (4) umfasst,
wobei an dem Rand (4) der Seitenwände (3) der Abschirmkappe (1) vertikal verstellbare Abschnitte (5) vorgesehen sind,
**dadurch gekennzeichnet, dass** mindestens ein Schlitz (7) an einem horizontal unteren Teil (6) einer jeden Seitenwand (3) der Abschirmkappe (1) vorgesehen ist,
wobei die Abschnitte (5) in dem an jeder Seitenwand (3) vorgesehen mindestens einen Schlitz (7) aufgehängt sind und sich frei gleitend durch den Schlitz (7) erstrecken.

2. Abschirmkappe nach Anspruch 1, **dadurch gekennzeichnet, dass** jeder Abschnitt (5) mit einem Vorsprung (8) an einem oberen Ende desselben versehen ist, welcher angepasst ist, um mit dem horizontalen unteren Teil (6) der Seitenwand (3) in Eingriff zu kommen.

## Revendications

1. Boîtier de blindage (1) pour blinder des composants électroniques sur une carte de câblage imprimée (9) dans un dispositif électronique, ledit boîtier de blindage (1) comprenant des parois latérales sensiblement verticales (3) avec un rebord inférieur (4),
dans lequel des sections verticalement réglables (5) sont disposées au niveau du rebord (4) des parois latérales (3) du boîtier de blindage (1),
**caractérisé en ce qu'**au moins une fente (7) est réalisée dans une partie inférieure horizontale (6) de chaque paroi latérale (3) du boîtier de blindage (1),
dans lequel les sections (5) sont suspendues dans la fente au nombre d'au moins une (7) réalisée dans chaque paroi latérale (3), et s'étendent de façon à pouvoir coulisser librement à travers la fente (7).

2. Boîtier de blindage selon la revendication 1, **caractérisé en ce que** chaque section (5) est munie d'une saillie (8) à une extrémité supérieure de celle-ci, adaptée de façon à venir en prise avec la partie inférieure horizontale (6) de la paroi latérale (3).
